Europäisches Patentamt

European Patent Office

Office européen des brevets

(11) Publication number: **0 279 683**
**A2**

# EUROPEAN PATENT APPLICATION

(21) Application number: 88301405.2

(22) Date of filing: **19.02.88**

(51) Int. Cl.⁴: **H 01 L 23/48**
**H 01 L 21/48**

(30) Priority: **20.02.87 JP 37316/87**

(43) Date of publication of application:
**24.08.88 Bulletin 88/34**

(84) Designated Contracting States: **DE FR GB**

(71) Applicant: **KABUSHIKI KAISHA TOSHIBA**
**72, Horikawa-cho Saiwai-ku**
**Kawasaki-shi Kanagawa-ken 210 (JP)**

(72) Inventor: **Shindo, Masamichi c/o Patent Division**
**Toshiba Corp. Principal Off. 1-1 Shibaura 1-chome**
**Minato-ku Tokyo (JP)**

(74) Representative: **Sturt, Clifford Mark et al**
**MARKS & CLERK 57-60 Lincoln's Inn Fields**
**London WC2A 3LS (GB)**

(54) Lead frame, semiconductor device using the same, and method of manufacture thereof.

(57) This invention provides a lead frame comprising, an inner lead section (4) which is arranged radially around the circumference of a semiconductor chip mounting region, an outer lead section (5) which extends outward from the inner lead section (4); a frame (1) which stably supports the inner and the outer lead sections (4, 5); and means (7) for linking the tips of the outer lead section (5) at positions separated from the frame (1) by units which each correspond to one side of the semiconductor chip.

Moreover, this invention provides a semiconductor device comprising a lead frame (1), a semiconductor chip mounted in the centre of the lead frame (1), a encapsulating compound (11) in such a way that the outer installation leads are exposed, and the intermediate sections of the outer leads (5) being shaped for connection to an external circuit with the inner sections and tip sections of the outer leads being buried in the encapsulating compound (11).

Furthermore, this invention provides a method of manufacturing a semiconductor device including a lead frame (1) provided with an inner lead section (4) which is arranged radially around the circumference of a semiconductor chip mounting region, an outer lead section (5) which extends outward from the inner lead section (4) and a frame (1) which stably supports the inner and the outer lead sections, comprising shaping the outer leads (5) for connection to an external circuit with the tips of the outer leads (5) linked at positions separated from the frame (1) by units which each correspond to one side of the semiconductor chip, mounting the semiconductor chip in the chip mounting region section of the lead frame (11), connecting wires between the inner leads (4) and the semiconductor chip, encapsulating the semiconductor device in a compound; and cutting off the linked sections (7) of the tips of the outer leads (5).

FIG.2.

**Description**

LEAD FRAME, SEMICONDUCTOR DEVICE USING THE SAME, AND METHOD OF MANUFACTURE THEREOF

This invention relates to a lead frame and, in particular, one which is used in a semiconductor package for surface mounting with a large number of pins. Moreover, this invention relates to a semiconductor device which uses this lead frame and the method of manufacturing thereof.

As the surface-mounting semiconductor packages most frequently used in the past, such packages as the "flat-pack" and the PLCC (Plastic Leaded Chip Carrier) are known.

The flat-pack has gull-wing shaped outer leads which are shaped so that they first extend horizontally from the circumference of the package, then bend downwards and then again bend horizontally. The tips of the outer leads of these gull-wing leads are cut after moulding and are then formed by a press.

Moreover, the PLCC has outer leads which are called "J" leads which extend downwards from the circumference of the package and which are bent in an arc at the lower ends. In this case also, the outer lead tips are formed after cutting from the frame.

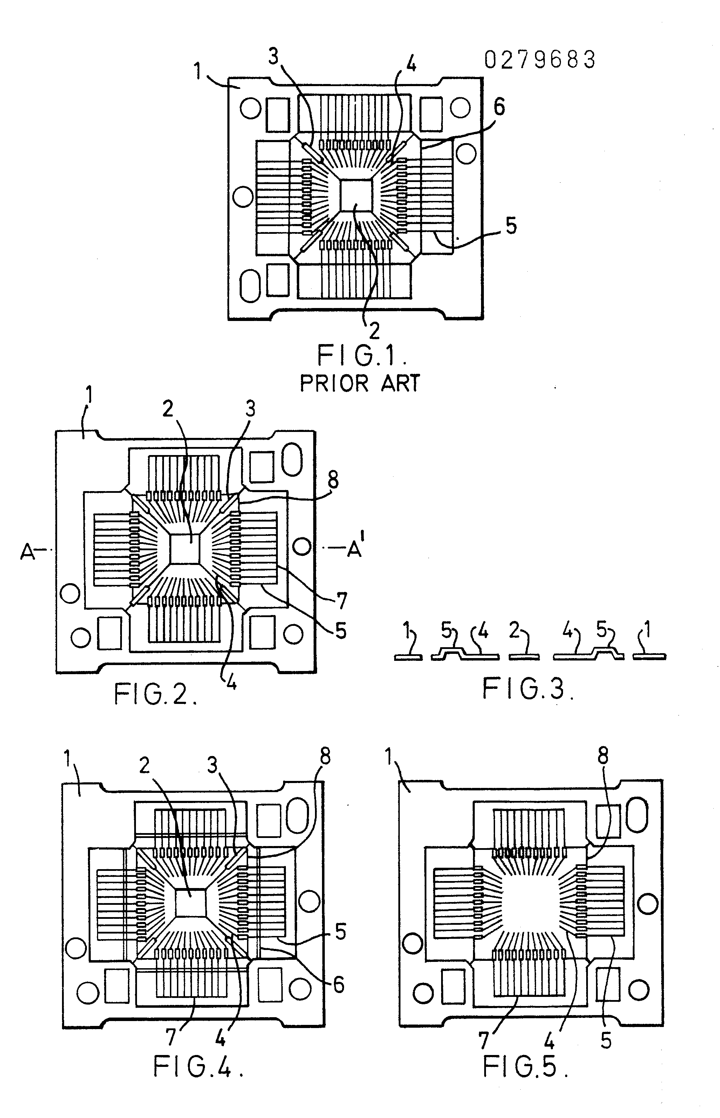

Figure 1 is a plan view of the lead frame used in the flat-pack and the PLCC. A bed 2 for mounting the semiconductor chip is positioned in the centre of a frame 1 and is supported on frame 1 by tie-bars 3. Inner leads 4 are arranged radially around the circumference of bed 2. The extensions of these inner leads 4 form outer leads 5 whose tips are joined to frame 1. Moreover, in order to prevent distortion of the inner leads, part of the outer leads are secured to frame 1 by dumb bar 6.

In this kind of lead frame, since the outer leads are supported by frame 1 and dumb bars 6, it is necessary to cut the tips of the outer leads away from frame 1 in order to carry out the shaping of the outer leads. As a result, when shaping the outer leads, the tips of the outer leads are free.

Since in the case of a conventional lead frame, the outer leads are secured by their tips to the lead frame body in this way, the shaping of the outer leads cannot be carried out after resin sealing until after the lead tips have been cut away from the frame. For this reason, distortions by small forces occur during the shaping after cutting away the lead tips from the frame body and during such operations as solder plating in order to improve solderability, and also during handling. Thus, it becomes extremely difficult to satisfy the users' specifications. Because of this, in the case of gull-wing leads, the limit is a total of about 150 pins for the 4 sides at a lead pitch of 0.65 mm, and this is an obstacle to achieving high densities because it prevents an increase in the number of pins. The same consideration applies for J-leads, but the number of pins is even further reduced since, while the outer leads are not easily affected by an external force because they bend inwards, the outer leads are, however, more greatly deformed.

An object of this invention is to provide a high-density lead frame which is most suitable for resin-sealed semiconductor devices, a semiconductor device which uses this lead frame and also a method of manufacturing for this device.

According to a first aspect of the present invention there is provided a lead frame comprising, an inner lead section which is arranged radially around the circumference of a semiconductor chip mounting region, an outer lead section which extends outward from the inner lead section, a frame which stably supports the inner and outer lead sections, and means for linking the tips of the outer lead section at positions separated from the frame by units which each correspond to one side of the semiconductor chip.

According to a second aspect of the present invention there is provided a semiconductor device comprising a lead frame, a semiconductor chip mounted in the centre of the lead frame, and a encapsulating compound in such a way that an outer installation leads are exposed, and the intermediate sections of the outer leads being shaped for connection to an external circuit with the inner sections and tip sections of the outer leads being buried in the encapsulating compound.

According to a third aspect of the present invention there is provided a method of manufacturing a semiconductor device including a lead frame provided with an inner lead section which is arranged radially around the circumference of a semiconductor chip mounting region, an outer lead section which extends outward from the inner lead section and a frame which stably supports the inner and the outer lead sections comprising shaping the outer leads for connection to an external circuit with the tips of the outer leads linked at positions separated from the frame by units which each correspond to one side of the semiconductor chip, mounting the semiconductor chip in the chip mounting region of the lead frame, connecting wires between the inner leads and the semiconductor chip, encapsulating the semiconductor device in a compound, and cutting off the linked sections of the tips of the outer leads.

When using a lead frame which embodies this invention, because the tips of the outer leads are linked in positions separated from the lead frame body, the leads alone can be shaped prior to encapsulating in moulding compound. Moreover, since the cutting of the lead tips may be carried out in the final stage, there is no risk of lead deformation by external forces or of lead pitch errors.

Moreover, in a semiconductor device which embodies this invention, since the outer leads, except for the installation sections, are buried in the moulding compound, this does not lead to pitch fluctuations of the outer lead tips or lead distortion when handling.

Furthermore, since the method of production of the semiconductor device according to the present invention is carried out as described above, deformation and pitch errors during production can be avoided.

Embodiments of this invention will now be described by way of example only and with reference to the accompanying drawings, in which:

Figure 1 is a plan view showing a conventional lead frame;

Figure 2 is a plan view showing the appearnce of a lead frame of an embodiment according to this invention;

Figure 3 is a cross-section along line A-A' of Figure 2 when lead-shaping is carried out;

Figures 4 and 5 are plan views showing examples of other embodiments of this invention;

Figures 6(a) - 6(e) are cross-sections showing an embodiment of the manufacturing method of this invention;

Figure 7 is an oblique view showing the appearance of an embodiment of the semiconductor device according to this invention produced by the manufacturing method of this invention;

Figure 8 is a cross-section of Figure 7;

Figure 9 is an oblique view of another embodiment of the semiconductor device according to this invention produced by the same method; and

Figure 10 is a cross-section of Figure 9.

Figure 2 is a plan view showing the construction of a lead frame according to this invention. The lead frame in this Figure differs from a conventional lead frame in the points that the tips of outer leads 5 are separated from frame 1 and are linked in units by link pieces 7 at positions parallel to the sides of bed unit 2, and that the leads at both ends of each side are linked to the frame by link pieces 8, instead of using dumb bars.

In this kind of lead frame, since the tips of the outer leads are separated from frame 1, it is possible to shape the outer leads prior to mounting the semiconductor chip on the bed unit. Figure 3 shows an example in which this kind of shaping is carried out and shows a cross-section along line A-A' of Figure 2. Lead 5 is bent into a rough U shape midway along its length in order to form a bonding section. It can be seen from this Figure that shaping of the outer leads is possible while still in the lead frame.

Figure 4 shows another embodiment of a lead frame according to this invention. In the case of this embodiment, there is a difference in that the outer leads on each side are linked to frame 1 by dumb bars 6 at their middles as well as at their tips. In the case of this embodiment, since each lead is supported more stably, the potential distortion and pitch error to each lead can be prevented more effectively. However, it is necessary to cut away dumb bars 6 in later processing.

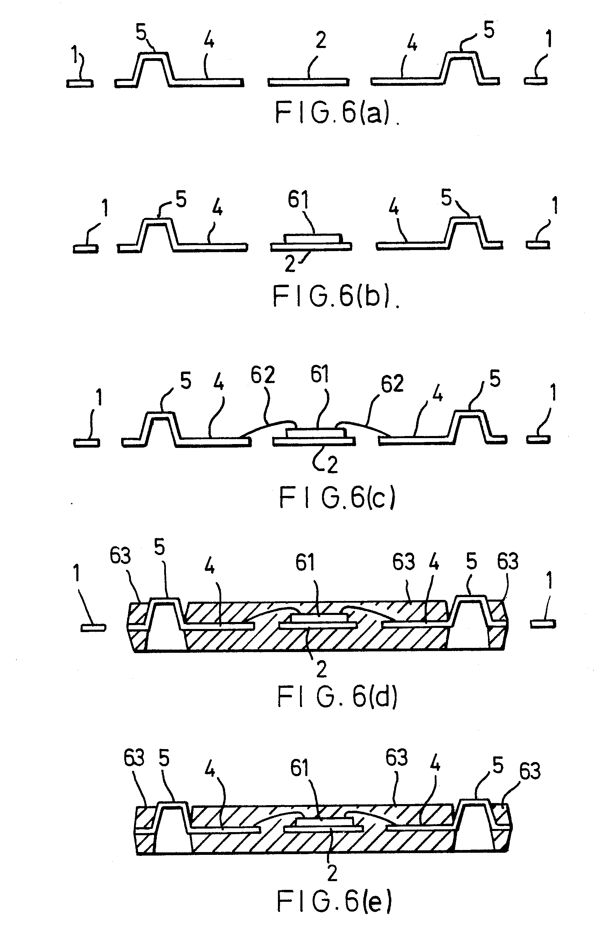

Figure 5 shows yet another embodiment of a lead frame according to this invention, in which the bed unit 2 and tie-bars 3 of the embodiment in Figure 2 are omitted. When this type of bed-less lead frame is used, resin tape or the like is employed to support the semiconductor chip. Also, by eliminating the bed unit, benefits such as improved high density, due to an increase in the number of leads, can be expected.

Next, a method of manufacturing a semiconductor device according to this invention will be explained.

After shaping of the outer leads, so that they have upwards or downwards convex shapes as shown in Figure 6(a), has been carried out by, for example, a press, the semiconductor chip 61 is mounted on bed 2. Alternatively, in the case of a bed-less lead frame, the semiconductor chip is taped to the lead frame, as shown in Figure 6(b). Known means are used for this mounting such as alloying or coating with conductive bonding material.

Next, as shown in Figure 6(c) the wiring 62 between the terminals on the semiconductor chip and the inner leads of the lead frame is carried out by known technology, such as wire-bonding.

As shown in Figure 6(d), the lead frame in which the wiring has been completed is placed in a mould-die (not shown) for encapsulating in moulding compound 63 and the encapsulating is carried out by the transfer moulding method.

After encapsulating has been completed, surface treatment such as solder-plating is carried out on the part which will be in contact with the printed board, in order to improve the solderability of the bonding section.

Finally, as shown in Figure 6(e), the unnecessary leads which project from the encapsulated body and linking pieces 7 are cut away by a press, and the semiconductor device is completed.

Since, in this kind of semiconductor device production process, the outer leads on each side are cut away from the linking pieces which link them at the end of the process, they are not easily affected by external forces during the various processes of lead-shaping, semiconductor chip mounting, wire-bonding, encapsulating, surface treatment and cutting away from the linking units. It is therefore difficult for lead deformation and pitch fluctuation to occur.

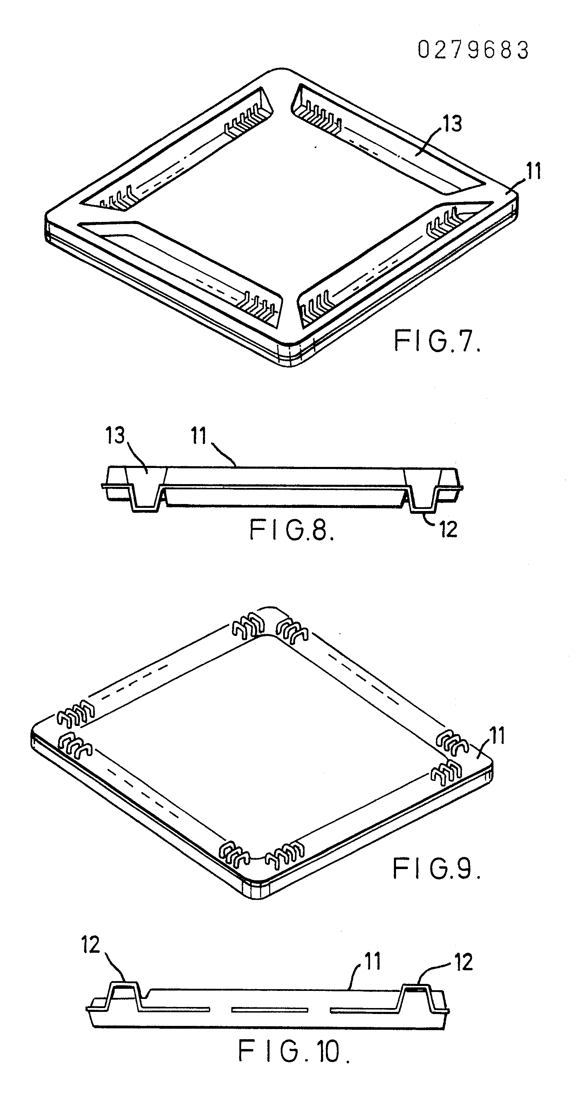

Examples of semiconductor devices manufactured in accordance with the present invention are shown in Figures 7 to 10. As shown by Figure 7 and more clearly by Figure 8, (which is a central cross-section of Figure 7) the under-surfaces 12 of the outer leads, which have been shaped in a downwards convex shape so as to form the sections which are to be bonded to a printed circuit board, project slightly from the under-surface of encapsulated body 11. Thus, bonding can be carried out easily. Also, in the vicinity of this outer lead bonding section, along each side of the device, there is provided an aperture 13 which extends through the device. The width of aperture 13 is about 1 - 1.5mm, for example. The height of the convex shape is, for example, about 1.5mm - 2mm when the side of mounting the semiconductor chip is the same as the projection side of the convex shape. On the other hand the height of the convex shape, for example, about 0.7mm - 1mm when the chip mounting side is opposite of the convex shape projection side. Therefore, during connection with the printed board, the formation of the solder fillet and the state of soldering can be easily confirmed.

In the case of Figure 9, the head and tail sides are the reverse of the case of Figure 7. The outer leads are made to project upwards but there is no aperture such as is provided in the case of Figure 7 and the compound is also extends to immediately below the projecting sections of the outer leads. In this case, two methods can be considered. One is the method, as shown on the left of Figure 10, where there is a gap between the encapsulated body surface and the inside of the bonding section. The other method is, as shown on the right, where the surface of the bonding section is in contact with the encapsulated body. However, the latter method has the characteristic of being simpler for mould-die construction.

In this kind of semiconductor device, since the inner sections and the tips of the outer leads are buried in the encapsulating compound with the exception of the bonding sections, there will be no risk of distortion of the outer leads and or of pitch fluctuation during handling or in the bonding process with the printed circuit board.

Thus, a semiconductor device produced by the method of this invention using a lead frame of this invention can achieve a lead pitch of 0.4 mm or less, and by this means high densities, with 200 pins or more, can be achieved without increasing the size of the device.

The shaping of the outer leads in this invention can be carried out at the same time as the lead frame is stamped out from a metal plate, and thus the processing can be simplified.

Moreover, the encapsulating compound in each corner of the device can be omitted as shown in Figure 7 and in this case a simpler metal mould is used.

In a lead frame according to this invention, since the tips of the outer leads are linked along each side of the device without being linked to the lead frame body, lead distortion and pitch fluctuation can be prevented during the production processes starting from lead-shaping. Also, reduction of lead pitch and increase of pins can be carried out with high accuracy.

Moreover, in a semiconductor device according to this invention, since the outer leads are buried in the compound apart from the connecting sections, lead distortion and pitch fluctuation can be prevented during handling and during the bonding process, so that the occurrence of inferior products is reduced.

Furthermore, using the semiconductor device production method according to this invention, semiconductor devices of the high quality described above can be easily produced.

Various modifications can be made to the described embodiments without departing from the scope of the invention.

## Claims

1. A lead frame comprising:
an inner lead section (4) which is arranged radially around the circumference of a semiconductor chip mounting region;
an outer lead section (5) which extends outward from the inner lead section (4); and
a frame (1) which stably supports the inner and outer lead sections (4, 5); characterised by
means (7) for linking the tips of the outer lead section (5) at positions separated from the frame (1) by units which each correspond to one side of the semiconductor chip.

2. A lead frame as claimed in claim 1, further characterised in that a bed section joined to the frame (1) is provided in the semiconductor chip mounting region.

3. A lead frame as claimed in claim 1 or 2, further characterised in that dumb bars (6) link the outer leads (5) on each side at a point midway along the outer leads (5).

4. A semiconductor device comprising:
a lead frame (1);
a semiconductor chip mounted in the centre of the lead frame (1); and
an encapsulating compound (11) in such a way that the outer installation leads are exposed; characterised by
intermediate sections of the outer leads (5) being shaped for connection to an external circuit with the inner sections and tip sections of the outer leads being buried in the encapsulating compound (11).

5. A semiconductor device as claimed in claim 4 further characterised in that the contact sections of the outer leads (5) are of U-shape cross-section of which the upper end is open.

6. A semiconductor device as claimed in claim 4 further characterised by the provision of apertures (13) which are open above the connecting sections of the outer leads (5).

7. A semiconductor device as claimed in claim 4 further characterised in that the encapsulating compound (11) surfaces coincide with the inner surfaces of the outer lead connecting sections (12).

8. A method of manufacturing a semiconductor device including a lead frame (1) provided with an inner lead section (4) which is arranged radially around the circumference of a semiconductor chip mounting region, an outer lead section (5) which extends outward from the inner lead section (4) and a frame (1) which stably supports the inner and the outer lead sections,
comprising:
shaping the outer leads (5) for connection to an external circuit with the tips of the outer leads (5) linked at positions separated from the frame (1) by units which each correspond to one side of the semiconductor chip;
mounting the semiconductor chip in the chip mounting region of the lead frame (1);
connecting wires between the inner leads (4) and the semiconductor chip;
encapsulating the semiconductor device in a compound; and
cutting off the linked sections (7) of the tips of the outer leads (5).

9. A method of manufacturing a semiconductor device as claimed in claim 8, further characterised in that the process of cutting the

**0 279 683**

linking sections (7) of the tips of the outer leads is carried out by a press.

10. A method of manufacturing a semiconductor device as claimed in claim 8, further characterised in that the process of shaping the outer leads (5) is carried out at the same time as the process of stamping out the outer leads from a metal plate.

0279683

FIG.1.
PRIOR ART

FIG.2.

FIG.3.

FIG.4.

FIG.5.

0279683

FIG.6(a).

FIG.6(b).

FIG.6(c)

FIG.6(d)

FIG.6(e)

0279683

FIG.7.

FIG.8.

FIG.9.

FIG.10.